# EUROPEAN PATENT APPLICATION

(11) **EP 4 760 465 A1**
(43) Date of publication of application: **17.06.2026**
(21) Application number: 23948967.7
(22) Date of filing: 25.09.2023
(51) Int. Cl.: G06F 3/041

(54) **DISPLAY PANEL AND DISPLAY DEVICE**

(30) Priority: 11.08.2023 CN 202311014931
(71) Applicant: Wuhan China Star Optoelectronics Semiconductor Display Technology Co., Ltd., Wuhan, Hubei 430079 (CN)
(72) Inventor: ZHENG, Yuan, Wuhan, Hubei 430079 (CN)
(74) Representative: Berggren Oy
(86) International application number: PCT/CN2023/121271
(87) International publication number: WO 2025/035544

(57) **Abstract**

A display panel and a display device are provided by the present disclosure. A first conductive layer includes a plurality of driving signal lines in the first wiring area. The driving signal lines are configured to load alternating current signals. A second conductive layer includes one or more shielding parts disposed in the first wiring area. A third conductive layer includes a plurality of touch traces, and the touch traces extend from the display area into at least the first wiring area. An orthographic projection of the one or more shielding parts on the substrate overlaps at least partially an orthographic projection of the driving signal lines on the substrate.

## Description

### TECHNICAL FIELD

The present disclosure relates to a field of display technologies, and in particular to display panels and display devices.

### BACKGROUND

With the continuous development of display technologies, more and more touch screens have been added to display devices. From the initial push button phones to today's smart touch phones, human-computer interaction methods have undergone tremendous changes. Touch interaction methods are likely to become the next generation of human-computer interaction methods, with potential application value. A touch screen is a simple and easy-to-use input device, and is configured to recognize the touch position or related information generated by users on the screen by contact or pressing with fingers, and to send the touch position or related information of the screen to the system.

At present, in organic light-emitting diode (OLED) display panels, a touch layer is generally disposed on an encapsulation layer of the OLED display panel. The touch layer includes touch traces extending to a non-display area. In addition, the non-display area is further provided with driving signal lines, which makes signals transmitted from the driving signal lines prone to crosstalk with signals of the touch traces, leading to the occurrence of abnormal touch control.

### SUMMARY

The embodiments of the present disclosure provide a display panel and a display device to improve signal crosstalk between driving signal lines and touch traces.

The embodiments of the present disclosure provide a display panel. The display panel includes a display area and a non-display area adjoining to the display area. The non-display area includes a wiring area and a bonding area located on a side of the wiring area away from the display area. The wiring area includes a first wiring area and a second wiring area adjoining to each other. The first wiring area is provided with a plurality of driving signal lines configured to load alternating current signals.

The display panel further includes:
a substrate;
a first conductive layer disposed on the substrate and comprising the driving signal lines;
a second conductive layer disposed on a side of the first conductive layer away from the substrate and including a plurality of power signal lines, wherein the power signal lines include a plurality of transmission parts and a plurality of connection parts, the transmission parts are disposed on a side of the second wiring area close to the display area, and the connection parts are connected between the transmission parts and the bonding area; and
a third conductive layer disposed on a side of the second conductive layer away from the first conductive layer and including a plurality of touch traces, wherein the touch traces extend from the display area into at least the first wiring area.

The second conductive layer further includes one or more shielding parts disposed in the first wiring area. The one or more shielding parts are connected to the transmission parts. An orthographic projection of the one or more shielding parts on the substrate overlaps at least partially an orthographic projection of the driving signal lines on the substrate.

Based on the above purpose of the present disclosure, the embodiments of the present disclosure provide a display device. The display device includes a display panel. The display panel includes a display area and a non-display area adjoining to the display area. the non-display area includes a wiring area and a bonding area located on a side of the wiring area away from the display area. The wiring area includes a first wiring area and a second wiring area adjoining to each other. The first wiring area is provided with a plurality of driving signal lines configured to load alternating current signals.

The display panel further includes:
a substrate;
a first conductive layer disposed on the substrate and including the driving signal lines;
a second conductive layer disposed on a side of the first conductive layer away from the substrate and including a plurality of power signal lines, wherein the power signal lines include a plurality of transmission parts and a plurality of connection parts, the transmission parts are disposed on a side of the second wiring area close to the display area, and the connection parts are connected between the transmission parts and the bonding area; and
a third conductive layer disposed on a side of the second conductive layer away from the first conductive layer and including a plurality of touch traces, wherein the touch traces extend from the display area into at least the first wiring area.

The second conductive layer further includes one or more shielding parts disposed in the first wiring area. The one or more shielding parts are connected to the transmission parts. An orthographic projection of the one or more shielding parts on the substrate overlaps at least partially an orthographic projection of the driving signal lines on the substrate.

### BRIEF DESCRIPTION OF THE DRAWINGS

With reference to the accompanying drawings, a detailed description of the specific implementation method of the present disclosure will make the technical solutions and other beneficial effects of the present disclosure obvious.
FIG. 1 is a plan structural schematic view of a display panel provided by the related art.
FIG. 2 is a schematic view of a cross-sectional structure of the display panel provided by the related art along an A-A line in FIG. 1.
FIG. 3 is a locally enlarged schematic view of a wiring plane distribution of the display panel provided by the related art at position B in FIG. 1.
FIG. 4 is a plan distribution schematic view of the display panel provided by an embodiment of the present disclosure.
FIG. 5 is a cross-sectional structural schematic view of the display panel provided by an embodiment of the present disclosure along an a-a line in FIG. 4.
FIG. 6 is a locally enlarged plan structural schematic view of the display panel provided by an embodiment of the present disclosure at position C1 in FIG. 4.
FIG. 7 is a schematic view of a distribution structure of the shielding part and the driving signal line provided in the embodiment of the present disclosure.
FIG. 8 is another schematic view of the distribution structure of the shielding part and the driving signal line provided by an embodiment of the present disclosure.
FIG. 9 is another cross-sectional structural schematic view of the display panel provided by an embodiment of the present disclosure along the a-a line in FIG. 4.
FIG. 10 is another locally enlarged plan structural schematic view of the display panel provided by an embodiment of the present disclosure at position C1 in FIG. 4.
FIG. 11 is another plan distribution structural schematic view of the display panel provided by an embodiment of the present disclosure.
FIG. 12 is a cross-sectional structural schematic view of the display panel provided by an embodiment of the present disclosure along an b-b line in FIG. 11.
FIG. 13 is a locally enlarged plan structural schematic view of the display panel provided by an embodiment of the present disclosure at position C2 in FIG. 11.
FIG. 14 is another plan distribution structural schematic view of the display panel provided by an embodiment of the present disclosure;
FIG. 15 is a cross-sectional structural schematic view of the display panel provided by an embodiment of the present disclosure along a c-c line in FIG. 14.
FIG. 16 is a locally enlarged plan structural schematic view of the display panel provided by an embodiment of the present disclosure at position C3 in FIG. 14.

### DETAILED DESCRIPTION

The technical solutions in the embodiments of the present disclosure will be described clearly and completely hereafter with reference to the accompanying drawings. Apparently, the described embodiments are only a part of but not all embodiments of the present disclosure. All other embodiments obtained by persons of ordinary skill in the art based on the embodiments of the present disclosure without creative efforts shall fall within the protection scope of the present disclosure.

Various embodiments and examples are provided in the following description to implement different structures of the present disclosure. In order to simplify the present disclosure, certain elements and settings will be described. However, these elements and settings are only by way of example and are not intended to limit the present disclosure. In addition, reference numerals may be repeated in different examples in the present disclosure. This repeating is for the purpose of simplification and clarity and does not refer to relations between different embodiments and/or settings. Furthermore, examples of different processes and materials are provided in the present disclosure. However, it would be appreciated by those skilled in the art that other processes and/or materials may be also applied.

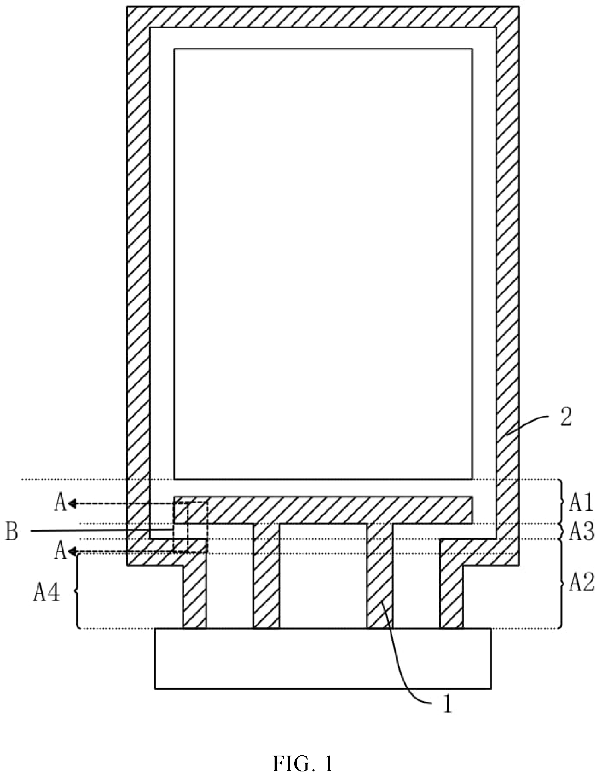

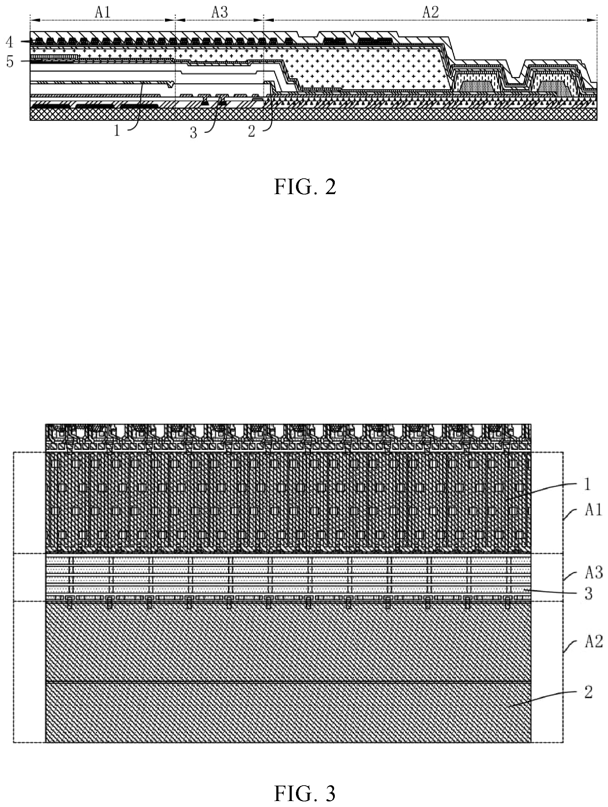

Referring to FIGs. 1, 2, and 3, a display panel of the related art includes a VDD power line 1 and a VSS power line 2, a plurality of driving signal lines 3, a plurality of touch traces 4, and a cathode layer 5 disposed in the display panel. The VDD power line 1 and the VSS power line 2 are both located between the driving signal lines 3 and the touch traces 4, and the cathode layer 5 is located between the VDD power line 1 and the touch traces 4. In the related art, due to alternating current signals loaded in the driving signal lines 3, it is easy to cause signal interference to the touch traces 4. Therefore, the cathode layer 5 is generally used to shield the driving signal lines 3 to reduce signal crosstalk. However, after verification, it was found that there is still severe signal crosstalk at the lower border of the display panel, which interferes with the signal transmitted in the touch traces 4 and affects the touch effect. Further research has found that at the cross-section shown in FIG. 2, the VDD power line 1 and the cathode layer 5 are located in the first area A1, the VSS power line 2 is located in the second area A2, and the touch traces 4 are located in the first area A1, the second area A2 and the third region A3. Furthermore, an organic layer between the VDD power line 1 and the cathode layer 5 in the second area A2 needs to be removed, and the area where the organic layer is removed is a fourth region A4, so as to block water vapor intrusion. The VDD power line 1 may be exposed during the process. In order to avoid short circuiting between the cathode layer 5 extending to the second area A2 and the exposed VDD power line 1, and taking into account issues such as the manufacturing accuracy and alignment accuracy of the cathode layer 5, a safe distance needs to be left between a boundary of the cathode layer 5 and the fourth area A4. Therefore, the cathode layer 5 is generally limited to the first area A1, resulting in the cathode layer 5 being unable to cover the third area A3, which makes it impossible to effectively shield the signal crosstalk between the driving signal lines 3 and the touch traces 4 through the cathode layer 5 at the lower border corresponding to the third region A3.

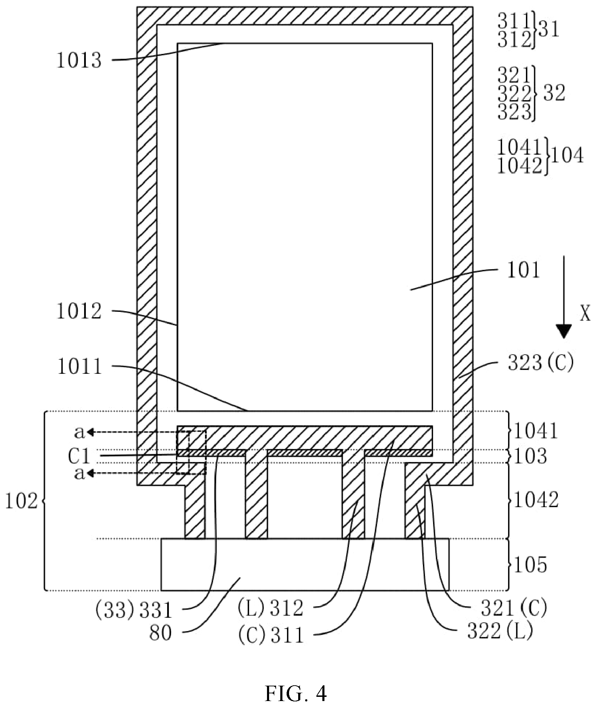

Referring to FIGs. 4, 5, and 6, the embodiments of the present disclosure further provides a display panel, which includes a display area 101 and a non-display area 102 adjoining to the display area 101. The non-display area 102 includes a first wiring area 103 and a second wiring area 104 adjoining to each other, and a bonding area 105 located on a side of the first wiring area 103 and second wiring area 104 away from the display area 101.

The display panel further includes a substrate 10, a first conductive layer 20, a second conductive layer 300, and a third conductive layer 400. The first conductive layer 20 is disposed on the substrate 10. The first conductive layer 20 includes a plurality of driving signal lines 21 disposed in the first wiring area 103. The driving signal lines 21 are configured to load alternating current signals. The second conductive layer 300 is disposed on a side of the first conductive layer 20 away from the substrate 10. The second conductive layer 300 includes a plurality of power signal lines 30. The power signal lines 30 includes a plurality of transmission parts C and a plurality of connection parts L. The transmission parts C are disposed on a side of the second wiring area 104 close to the display area 101. The connection parts L are connected between the transmission parts C and the bonding area 105. The third conductive layer 400 is disposed on a side of the second conductive layer 300 away from the first conductive layer 20. The third conductive layer 400 includes a plurality of touch traces 40, which extends from the display area 101 into at least the first wiring area 103.

Furthermore, the second conductive layer 300 further includes one or more shielding parts 33 located in the first wiring area 103. The shielding parts 33 are connected to the transmission parts C. An orthographic projection of the shielding parts 33 on the substrate 10 overlaps at least partially with an orthographic projection of the driving signal lines 21 on the substrate 10.

The embodiments of the present disclosure add the shielding parts 33 in the first wiring area 103. The shielding parts 33 are connected to the transmission parts C. The shielding parts 33 overlap at least partially the driving signal lines 21 to shield the signal interference of the driving signal lines 21 on the touch traces 40, thereby reducing the crosstalk between the touch traces 40 and the driving signal lines 21, and improving the touch effect of the display panel.

Specifically, please continue to refer to FIGs. 4, 5, and 6, the display panel provided by the embodiments of the present disclosure includes a display area 101 and a non-display area 102, and the non-display area 102 may be a border area surrounding the display area 101. In the lower border of the display panel, the non-display area 102 includes a wiring area and a bonding area 105 located on a side of the wiring area away from the display area 101. The wiring area may include a first wiring area 103 and a second wiring area 104 adjoining to the first wiring area 103.

In one embodiment, the second wiring area 104 may be connected to opposite sides of the first wiring area 103. The second wiring area 104 may include a first sub area 1041 and a second sub area 1042 located on opposite sides of the first wiring area 103, respectively. The first sub area 1041 is located between the first wiring area 103 and the display area 101. The second sub area 1042 is located between the first wiring area 103 and the bonding area 105. The wiring area in subsequent embodiments will be described taking the above layout as an example.

The display panel further includes a substrate 10, a semiconductor layer 61, a fourth conductive layer 50, the first conductive layer 20 sequentially arranged on the substrate 10, and a plurality of insulation layers disposed between any two of the semiconductor layer 61, the fourth conductive layer 50, the first conductive layer 20, or the second conductive layer 300.

The semiconductor layer 61 includes an active layer disposed in the display area 101. The fourth conductive layer 50 may include a plurality of functional signal lines 51 located in the non-display area 102. The first conductive layer 20 includes a plurality of sources, a plurality of drains, a plurality of data lines, and the like disposed in the display area 101, and the driving signal lines 21 disposed in the first wiring area 103. The driving signal lines 21 are configured to load alternating current signals.

In one embodiment, the driving signal lines 21 are electrically connected to a multiplexing circuit. For example, the driving signal lines 21 may be connected to the multiplexing circuit through the functional signal lines 51, and one multiplexing circuit may be connected to at least two data lines.

In one embodiment, the driving signal lines 21 may be further configured to load clock signals and may be connected to a gate drive circuit through the functional signal lines 51.

The display panel further includes a first organic flat layer 62 disposed on the first conductive layer 20, a second conductive layer 300 disposed on the first organic flat layer 62, a second organic flat layer 63 disposed on the second conductive layer 300, a pixel definition layer 64 disposed on the second organic flat layer 63, an organic light-emitting layer 65 disposed on the pixel definition layer 64, a cathode layer 66 and a protective layer 67 disposed on the organic light-emitting layer 65, an encapsulation layer 70 disposed on the protective layer 67, and the third conductive layer 400 disposed on the encapsulation layer 70.

The second conductive layer 300 includes the power signal lines 30 disposed in the non-display area 102. The encapsulation layer 70 includes a first inorganic encapsulation layer 71, an organic encapsulation layer 72, and a third inorganic encapsulation layer 73 sequentially disposed on the protective layer 67. The third conductive layer 400 includes the touch traces 40 disposed on the encapsulation layer 70.

In one embodiment, the touch traces 40 may include a first touch trace 41 and a second touch trace 42, and one of the first touch trace 41 and the second touch trace 42 may be a transmitting signal line and the other may be a receiving signal line. The display panel further includes a plurality of insulation layers disposed between the touch traces 40 and the encapsulation layer 70, disposed between the first touch trace 41 and the second touch trace 42, or disposed on and covering the second touch trace 42.

In the embodiments of the present disclosure, the touch traces 40 extend from the display area 101 into the non-display area 102, and may extend to the first sub area 1041, the first wiring area 103, and the second sub area 1042. Therefore, there is an overlap between the touch traces 40 and the driving signal lines 21. Due to the alternating current signal loaded in the driving signal lines 21, it is easy to cause signal interference to the touch traces 40. In one embodiment, an orthographic projection of the touch traces 40 on the substrate 10 overlaps at least partially an orthographic projection of the driving signal lines 21 on the substrate 10. The extension direction of the touch traces 40 in the first wiring area 103 may be the same as or intersect with the extension direction of the driving signal lines 21 in the first wiring area 103. For example, the extension direction of touch traces 40 in the first wiring area 103 and the extension direction of the driving signal lines 21 in the first wiring area 103 may be perpendicular to a first direction X, and the first direction X is a direction of the first sub area 1041 pointing towards the second sub area 1042.

However, in the embodiments of the present disclosure, the second conductive layer 300 further includes the shielding parts 33 located in the first wiring area 103, and the orthographic projection of the shielding parts 33 on the substrate 10 overlaps at least partially the orthographic projection of the driving signal lines 21 on the substrate 10 to reduce signal crosstalk between the driving signal lines 21 and the touch traces 40, thereby improving the touch effect of the display panel.

Furthermore, the power signal lines 30 include the transmission parts C close to the display area 101 and the connection parts L connected between the transmission parts C and the bonding area 105 at least through the first wiring area 103. The shielding parts 33 are connected to the transmission parts C, as detailed in subsequent embodiments.

In one embodiment, the shielding parts 33 are provided with a plurality of openings 330. Due to the first organic flat layer 62 is below the shielding parts 33, and in order to avoid that gas emission from the first organic flat layer 62 during subsequent high-temperature processes may cause damage to the second conductive layer 300, the openings 330 are provided in the second conductive layer 300 to allow the gas to pass through.

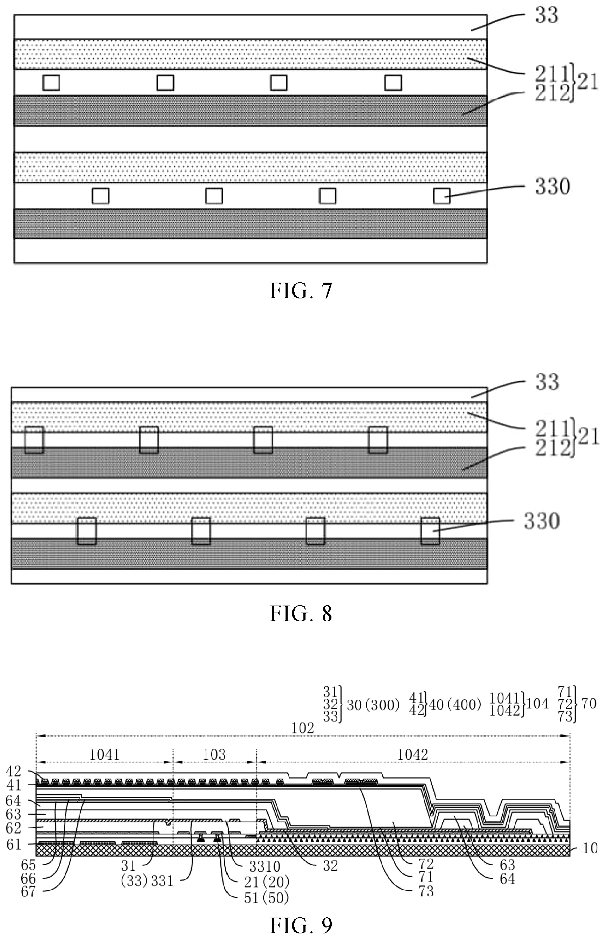

In one embodiment, as shown in FIG. 7, the orthographic projection of the driving signal lines 21 on the substrate 10 does not overlap the orthographic projection of the openings 330 on the substrate 10. For example, the driving signal lines 21 is disposed to avoid the openings 330, or holes are dug at the position of the driving signal line 21 corresponding to the opening 330, which may make the driving signal lines 21 more blocked by the shielding parts 33 to improve the shielding effect of the shielding parts 33 for signal interference.

In another embodiment, as shown in FIG. 8, the orthographic projection of the driving signal lines 21 on the substrate 10 overlaps the orthographic projection of the openings 330 on the substrate 10. Specifically, the driving signal lines 21 may include a first trace 211 and a second trace 212. The overlap area between the orthographic projection of the first trace 211 on the substrate 10 and the orthographic projection of the openings 330 on the substrate 10 is equal to the overlap area between the orthographic projection of the second trace 212 on the substrate 10 and the orthographic projection of the openings 330 on the substrate 10. The electrical signal loaded in the first trace 211 is the same as the electrical signal loaded in the second trace 212. Due to the overlap of the first trace 211 and the second trace 212 with the shielding parts 33, capacitance is generated which may affect the load in the first trace 211 and the second trace 212. In the embodiments of the present disclosure, the exposed areas of the first trace 211 and the second trace 212 through the openings 330 are controlled to be the same, which may result in the shielding parts 33 having the same load impact on the first trace 211 and the second trace 212, so as to avoid affecting the display effect of the display panel due to different loads on the first trace 211 and second trace 212 that transmit the same signal.

It can be understood that the display panel further includes a driving component 80 located in the bonding area 105. The connection parts L are connected between the transmission parts C and the driving component 80 at least through the first wiring area 103.

In an embodiment of the present disclosure, referring to FIGs. 4, 5, and 6, the power signal lines 30 include a first power line 31 and a second power line 32. The transmission parts C include a first transmission part 311, a second transmission part 321, and an auxiliary transmission part 323. The connection parts L include a first connection part 312 and a second connection part 322.

The first power line 31 includes a first transmission part 311 close to the display area 101 and a first connection part 312 connected between the first transmission part 311 and the driving component 80. The first transmission part 311 is located in the first sub area 1041. One end of the first connection part 312 is connected to the first transmission part 311, and another end of the first connection part 312 passes through the first wiring area 103 and the second sub area 1042 and is connected to the driving component 80.

The second power line 32 includes a second transmission part 321 located close to the display area 101 and located in the second sub area 1042, a second connection part 322 connected between the second transmission part 321 and the driving component 80, and an auxiliary transmission part 323 connected to the second transmission part 321. One end of the second connection part 322 is connected to the second transmission part 321, and another end of the second connection part 322 passes through the second sub area 1042 and is connected to the driving component 80. The auxiliary transmission part 323 is connected to the second transmission part 321 and passes through the first wiring area 103 and the first sub area 1041 to surround a part of the display area 101.

Specifically, the display area 101 includes a first side 1011 close to the bonding area 105. Both the first transmission part 311 and the second transmission part 321 are disposed close to the first side 1011. The display area 101 further includes two second sides 1012 connected to opposite sides of the first side 1011, and a third side 1013 connected to two second sides 1012 and opposite to the first side 1011. The second transmission part 321 is connected to the auxiliary transmission part 323 to surround the second sides 1012, the third side 1013, and a part of the first side 1011 of the display area 101.

In the embodiment of the present disclosure, the transmission parts C of the power signal lines 30 are parallel to the first side 1011. The connection parts L of the power signal lines 30 intersects with the first side 1011. For example, they may be perpendicular to each other. Specifically, the first transmission part 311 and the second transmission part 321 are parallel to the first side 1011. The first connection part 312 and the second connection part 322 intersect with the first side 1011.

In one embodiment, the first power line 31 may be a VDD signal line, and the second power line 32 may be a VSS signal line.

The shielding part 33 includes a first shielding part 331 located in the first wiring area 103 and connected to the first transmission part 311. The first shielding part 331 is parallel to and opposite to the first side 1011. The orthographic projection of the first shielding part 331 on the substrate 10 overlaps partially the orthographic projection of the driving signal line 21 on the substrate 10.

In one embodiment, the first shielding part 331 are connected to a part of the first connection part 312 in the first wiring area 103. In the first wiring area 103, the orthographic projection of the driving signal lines 21 on the substrate 10 is located in the orthographic projection of the first shielding part 331 and the first connection part 312 on the substrate 10. In the first wiring area 103, the orthographic projection of the driving signal lines 21 on the substrate 10 is located in the orthographic projection of the first shielding part 331 on the substrate 10, or an orthographic projection of a part of the driving signal line 21 is located in the orthographic projection of the first shielding part 331 on the substrate 10, and an orthographic projection of another part of the driving signal line 21 is located in the orthographic projection of the first connection part 312 on the substrate 10.

It can be understood that the first shielding part 331 may be integrally formed with the first transmission part 311, that is, the first shielding part 331 may be integrally formed with the first power line 31.

In one embodiment, the first shielding part 331 is provided with a plurality of first openings 3310. The first transmission part 311 is provided with a plurality of third openings 310. Due to the first organic flat layer 62 is disposed below the first shielding part 331, and in order to avoid gas emission from the first organic flat layer 62 during subsequent high-temperature processes, which may cause damage to the second conductive layer 300, the first openings 3310 and the third opening 310 are disposed in the second conductive layer 300 to allow the gas to pass through.

The areas of the first openings 3310 and the third opening 310 may be the same or different, and may be selected according to actual needs, without limitation here.

In one embodiment, the power signal lines 30 is configured to load direct current signals, that is both the first power line 31 and the second power line 32 are loaded with the direct current signals. The first shielding part 331 is also loaded with direct current signals, which may shield the alternating current signal loaded in the driving signal lines 21 from the signal crosstalk generated by the touch traces 40, to improve the touch effect of the display panel.

The first shielding part 331 is spaced apart from the second power line 32 to avoid a short circuit between the first power line 31 and the second power line 32.

In one embodiment, a width of the area between the first sub area 1041 and the second sub area 1042 along the first direction X is a first width, that is, a width of the first wiring area 103 along the first direction X is the first width. A width of the first shielding part 331 along the first direction X is a second width, and the difference between the first width and the second width is greater than or equal to 10 microns and less than or equal to 30 microns. The distance from the first shielding part 331 in the first direction X to the second transmission part 321 is greater than or equal to 10 microns and less than or equal to 30 microns.

Furthermore, in the embodiment, the first shielding part 331 connected to the first transmission part 311 is added in the first wiring area 103, which may shield the driving signal line 21 below, thereby reducing the signal crosstalk caused by the alternating current signals in the driving signal lines 21 to the touch traces 40 and improving the touch effect of the display panel.

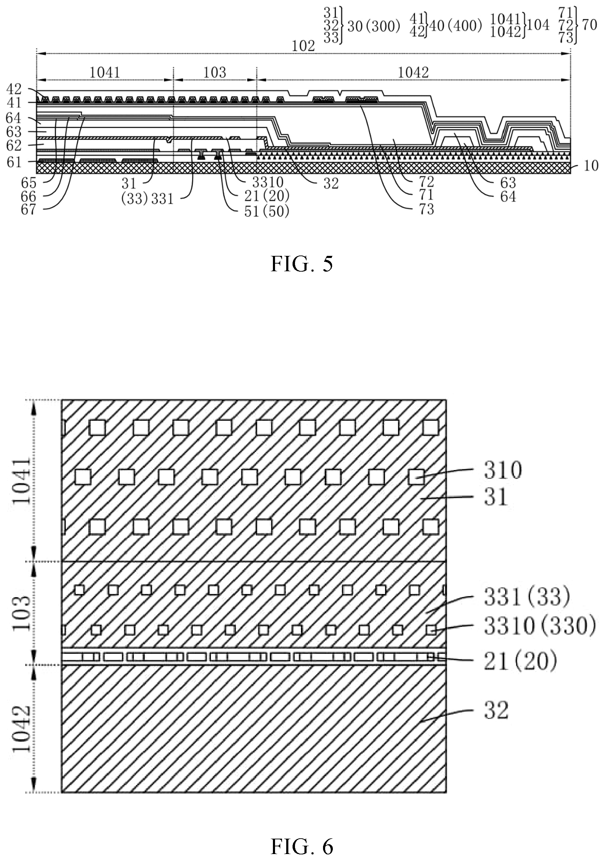

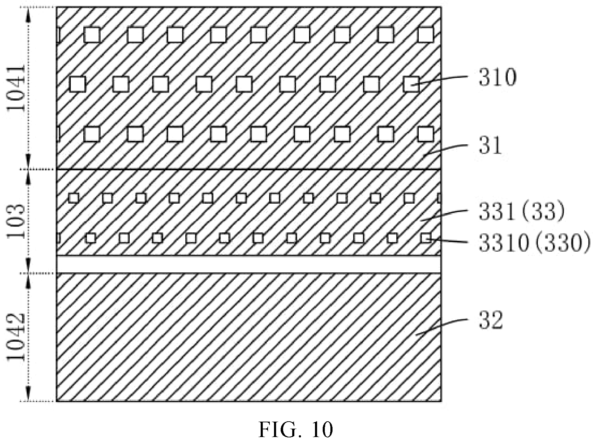

In another embodiment of the present disclosure, referring to FIGs. 9 and 10, the difference between the embodiment and the embodiment shown in FIGs. 5 and 6 is that the orthographic projection of the driving signal lines 21 on the substrate 10 is located in the orthographic projection of the first shielding part 331 and the first connection part 312 on the substrate 10.

Furthermore, the first shielding part 331 added in the embodiment may shield all the driving signal lines 21, further improving the shielding effect of the shielding part 33 and the touch control effect of the display panel.

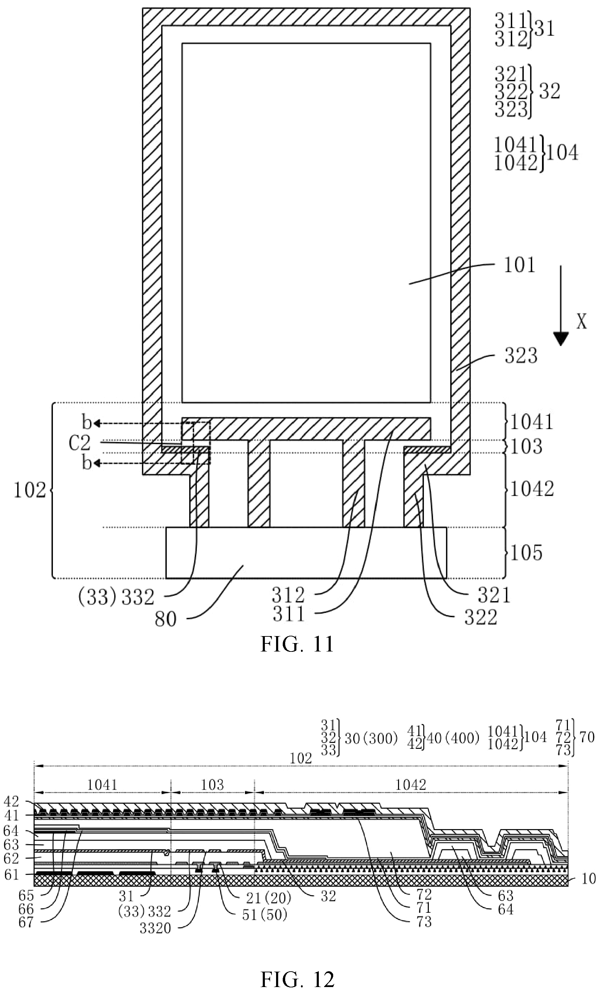

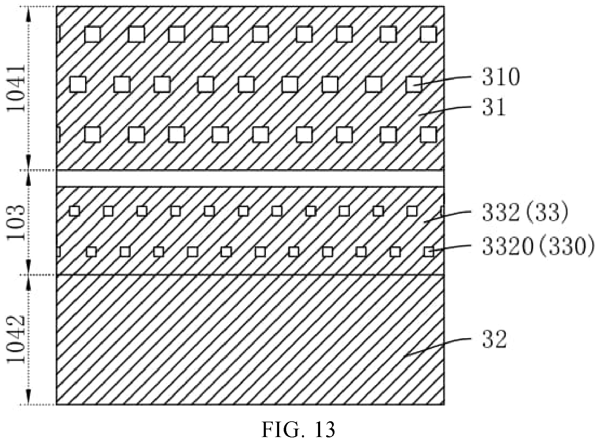

In another embodiment of the present disclosure, referring to FIGs. 11, 12, and 13, the difference between the embodiment and the embodiment shown in FIGs. 5 and 6 is that the shielding part 33 includes a second shielding part 332 located in the first wiring area 103 and connected to the second transmission part 321.

The second shielding part 332 may be integrally formed with the second transmission part 321, that is, the second shielding part 332 may be integrally formed with the second power line 32, and the second shielding part 332 is parallel to the first side 1011.

In one embodiment, the distance from the second shielding part 332 to the first transmission part 311 along the first direction X is greater than or equal to 10 microns and less than or equal to 30 microns.

In one embodiment, a plurality of second openings 3320 are defined in the second shielding part 332 to release gas generated by the process in the first organic flat layer 62.

The areas of the second opening 3320 and the third opening 310 may be the same or different, and may be selected according to actual needs, without limitation here.

Furthermore, in the embodiment, a second shielding part 332 connected to the second transmission part 321 is added in the first wiring area 103 to shield the driving signal lines 21 below, thereby reducing the signal crosstalk generated by the alternating current signal in the driving signal lines 21 on the touch traces 40 and improving the touch effect of the display panel.

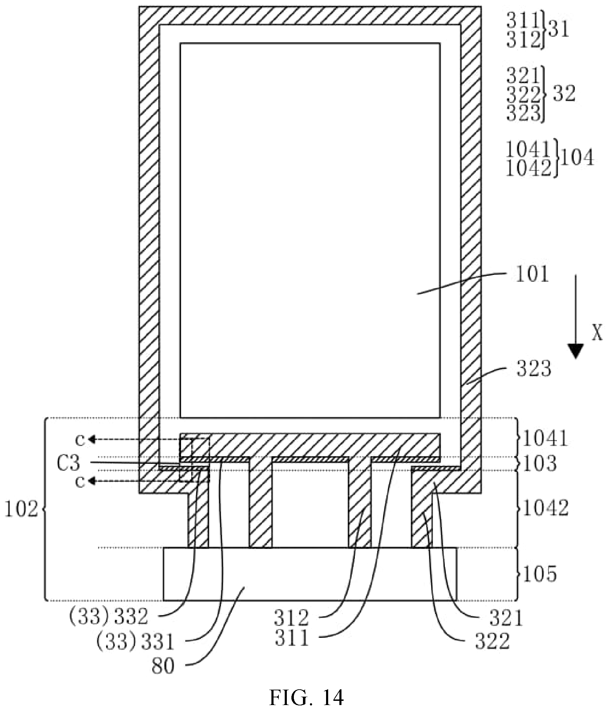

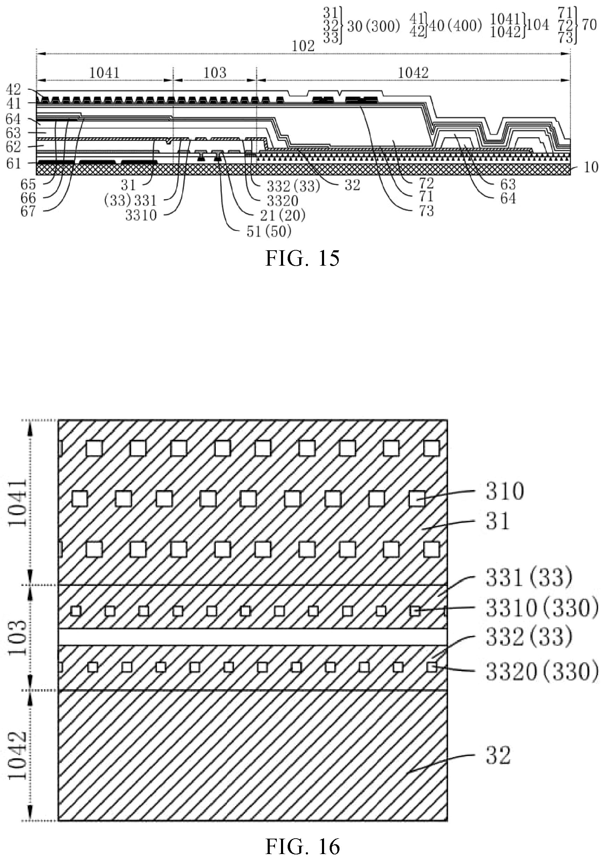

In another embodiment of the present disclosure, referring to FIGs. 14, 15, and 16, the difference between the embodiment and the embodiment shown in FIGs. 5 and 6 is that the shielding parts 33 includes a first shielding part 331 and a second shielding part 332. The first shielding part 331 is located in the first wiring area 103 and is connected to the first transmission part 311. The second shielding part 332 is located in the first wiring area 103 and is connected to the second transmission part 321.

The first shielding part 331 may be integrally formed with the first transmission part 311. The second shielding part 332 may be integrally formed with the second transmission part 321. Both the first shielding part 331 and the second shielding part 332 are parallel to the first side 1011.

In one embodiment, the distance from the first shielding part 331 to the second shielding part 332 along the first direction X is greater than or equal to 10 microns and less than or equal to 30 microns.

In one embodiment, the first shielding part 331 is provided with a plurality of first openings 3310, and the second shielding part 332 is provided with a plurality of second openings 3320 to release gas generated by the process in the first organic flat layer 62.

Furthermore, in the embodiment, a first shielding part 331 connected to the first transmission part 311 and a second shielding part 332 connected to the second transmission part 321 are added in the first wiring area 103, so as to shield the driving signal lines 21 below, thereby reducing the signal crosstalk generated by the alternating current signal in the driving signal lines 21 on the touch traces 40 and improving the touch effect of the display panel.

In addition, the present disclosure embodiments further provide a display device, which includes a display panel. The display panel is the display panel described in the above embodiments.

The display device may include display devices such as televisions, mobile phones, computers, and tablets.

In the above embodiments, the descriptions of each embodiment have their own emphasis. For the parts that are not detailed in one embodiment, referring to the relevant descriptions of other embodiments.

The display panel and the display device provided by the embodiments of the present disclosure are described in detail above. The principle and implementations of the present disclosure are described in this specification by using specific examples. The description about the foregoing embodiments is merely provided to help understand the method and core ideas of the present disclosure. Persons of ordinary skill in the art should understand that they may still make modifications to the technical solutions described in the foregoing embodiments or make equivalent replacements to some technical features thereof, without departing from the scope of the technical solutions of the embodiments of the present disclosure.

## Claims

1. A display panel, comprising a display area and a non-display area adjoining to the display area, wherein the non-display area comprises a wiring area and a bonding area located on a side of the wiring area away from the display area, the wiring area comprises a first wiring area and a second wiring area adjoining to each other, and the first wiring area is provided with a plurality of driving signal lines configured to load alternating current signals;
wherein the display panel further comprises:
a substrate;
a first conductive layer disposed on the substrate and comprising the driving signal lines;
a second conductive layer disposed on a side of the first conductive layer away from the substrate and comprising a plurality of power signal lines, wherein the power signal lines comprise a plurality of transmission parts and a plurality of connection parts, the transmission parts are disposed on a side of the second wiring area close to the display area, and the connection parts are connected between the transmission parts and the bonding area; and
a third conductive layer disposed on a side of the second conductive layer away from the first conductive layer and comprising a plurality of touch traces, wherein the touch traces extend from the display area into at least the first wiring area;
wherein the second conductive layer further comprises one or more shielding parts disposed in the first wiring area, the one or more shielding parts are connected to the transmission parts, and an orthographic projection of the one or more shielding parts on the substrate overlaps at least partially an orthographic projection of the driving signal lines on the substrate.

2. The display panel of claim 1, wherein the power signal lines are configured to load direct current signals.

3. The display panel of claim 1, wherein the display area comprises a first side close to the bonding area, the transmission parts are parallel to the first side, and extension lines defined by the connection parts intersect with the first side.

4. The display panel of claim 3, wherein the one or more shielding parts are disposed parallel to the first side.

5. The display panel of claim 3, wherein the second wiring area comprises a first sub area and a second sub area located on opposite two sides of the first wiring area, the first sub area adjoins to the first side, the second sub area is located on a side of the first wiring area away from the first side, the power signal lines comprise a first power line and a second power line, the first power line comprises a first transmission part located in the first sub area and a plurality of first connection parts connected between the first transmission part and the bonding area, and the second power line comprises at least one second transmission part located in the second sub area and a plurality of second connection parts connected between the second transmission part and the bonding area; and
wherein the one or more shielding parts are connected to the first transmission part and/or the second transmission part, and the first power line is insulated from the second power line.

6. The display panel of claim 5, wherein the shielding part comprises a first shielding part connected to the first transmission part, and the first shielding part is spaced apart from the second power line.

7. The display panel of claim 6, wherein in the first wiring area, the first shielding part is connected to the first connection parts, and the orthographic projection of the driving signal lines on the substrate is located within an orthographic projection of the first shielding part and the first connection parts on the substrate.

8. The display panel of claim 5, wherein the shielding part comprises a second shielding part connected to the second transmission part, and the second shielding part is spaced apart from the first power line.

9. The display panel of claim 5, wherein the shielding parts comprise a first shielding part connected to the first transmission part and a second shielding part connected to the second transmission part, and the first shielding part and the second shielding part are disposed in intervals.

10. The display panel of claim 5, wherein the display area further comprises two second sides connected to two ends of the first side, and a third side connected to the two second sides and opposite to the first side; and
wherein the first transmission part of the first power line is disposed opposite to and parallel to the first side; and
the second power line further comprises an auxiliary transmission part, and the second transmission part is connected to the auxiliary transmission part to surround the second sides, the third side, and a part of the first side of the display area.

11. The display panel of claim 5, wherein a width of the first wiring area along a first direction is a first width, the first direction is a direction of the first sub area pointing towards the second sub area, a width of the one or more shielding parts along the first direction is a second width, and a difference between the first width and the second width is greater than or equal to 10 microns and less than or equal to 30 microns.

12. The display panel of claim 1, wherein the orthographic projection of the one or more shielding parts on the substrate overlaps at least partially an orthographic projection of the touch traces on the substrate, and the orthographic projection of the touch traces on the substrate overlaps at least partially with the orthographic projection of the driving signal lines on the substrate.

13. The display panel of claim 1, wherein the display panel further comprises a first organic flat layer disposed between the first conductive layer and the second conductive layer, and the one or more shielding parts are provided with a plurality of openings.

14. The display panel of claim 13, wherein the orthographic projection of the driving signal lines on the substrate does not overlap an orthographic projection of the openings on the substrate.

15. The display panel of claim 13, wherein the driving signal lines comprise a first trace and a second trace, an overlap area between an orthographic projection of the first trace on the substrate and the orthographic projection of the openings on the substrate is equal to an overlap area between an orthographic projection of the second trace on the substrate and the orthographic projection of the openings on the substrate, and an electrical signal loaded in the first trace is same as an electrical signal loaded in the second trace.

16. The display panel of claim 1, wherein the display panel further comprises a fourth conductive layer disposed between the first conductive layer and the substrate, the fourth conductive layer comprises a plurality of functional signal lines, and the functional signal lines extend from the display area into the first wiring area and are connected to the driving signal lines.

17. The display panel of claim 1, wherein the display panel further comprises a driving component disposed in the bonding area, and the connection parts are connected between the transmission parts and the driving component at least passing through the first wiring area.

18. A display device, comprising a display panel, wherein the display panel comprises a display area and a non-display area adjoining to the display area, wherein the non-display area comprises a wiring area and a bonding area located on a side of the wiring area away from the display area, the wiring area comprises a first wiring area and a second wiring area adjoining to each other, and the first wiring area is provided with a plurality of driving signal lines configured to load alternating current signals;
wherein the display panel further comprises:
a substrate;
a first conductive layer disposed on the substrate and comprising the driving signal lines;
a second conductive layer disposed on a side of the first conductive layer away from the substrate and comprising a plurality of power signal lines, wherein the power signal lines comprise a plurality of transmission parts and a plurality of connection parts, the transmission parts are disposed on a side of the second wiring area close to the display area, and the connection parts are connected between the transmission parts and the bonding area; and
a third conductive layer disposed on a side of the second conductive layer away from the first conductive layer and comprising a plurality of touch traces, wherein the touch traces extend from the display area into at least the first wiring area;
wherein the second conductive layer further comprises one or more shielding parts disposed in the first wiring area, the one or more shielding parts are connected to the transmission parts, and an orthographic projection of the one or more shielding parts on the substrate overlaps at least partially an orthographic projection of the driving signal lines on the substrate.

19. The display device of claim 18, wherein the power signal lines are configured to load direct current signals.

20. The display device of claim 18, wherein the orthographic projection of the one or more shielding parts on the substrate overlaps at least partially an orthographic projection of the touch traces on the substrate, and the orthographic projection of the touch traces on the substrate overlaps at least partially with the orthographic projection of the driving signal lines on the substrate.
